# EUROPEAN PATENT APPLICATION

(11) **EP 1 705 707 A2**
(43) Date of publication of application: **27.09.2006**
(21) Application number: 06005870.8
(22) Date of filing: 22.03.2006
(51) Int. Cl.: H01L 27/146

(54) **Method for manufacturing image recording medium**

(30) Priority: 22.03.2005 JP 2005081066
(71) Applicant: FUJI PHOTO FILM CO., LTD., Minami-Ashigara-shi, Kanagawa (JP)
(72) Inventor: Nakatsugawa, Haruyasu, Ashigarakami-gun Kanagawa-ken (JP); Kaito, Ryouzou, Ashigarakami-gun Kanagawa-ken (JP)
(74) Representative: Höhfeld, Jochen

(57) **Abstract**

A method for manufacturing an image recording medium constituted by a layer composite layered in the order of: a recording side electrode layer (11) transparent to recording radiation; a recording photoconductive layer (12) that shows photoconductivity when exposed to the recording radiation; a charge storage section (31) for storing charges of a latent image polarity generated in the recording photoconductive layer (12); a readout photoconductive layer (14) that shows photoconductivity when exposed to a readout electromagnetic wave; and a readout side electrode layer (15) transparent to the readout electromagnetic wave. In the layer composite, either of the recording photoconductive layer (12) or readout photoconductive layer (14) consists primarily of a-Se, and the other consists primarily of sintered compacts of Bi-system compound. The photoconductive layer consisting primarily of a-Se is formed by deposition after the photoconductive layer consisting primarily of sintered compacts of Bi-system compound is formed.

## Description

### BACKGROUND OF THE INVENTION

### Field of the Invention

The present invention relates to a method for manufacturing an image recording medium capable of recording image information as an electrostatic latent image.

### Description of the Related Art

In the medical radiation imaging, image recording media that include a radiation sensitive photoconductor are used abundantly for reducing the radiation dosage received by the subject and improving diagnostic performance. When radiation is irradiated on the image recording medium that includes the photoconductor, electric charges (latent image charges) are stored in the medium according to the dose of the radiation. Thereafter, the radiation image information may be read out from the image recording medium by detecting the charges stored in the medium.

An image recording medium constituted by a layer composite is known as such image recording medium. The layer composite includes: a recording side electrode layer transparent to recording radiation; a recording photoconductive layer that shows photoconductivity when exposed to the recording radiation; a readout photoconductive layer that shows photoconductivity when exposed to a readout electromagnetic wave; a readout side electrode layer transparent to the readout electromagnetic wave. In such image recording medium, it is conceivable that a photoconductive material consisting primarily of a-Se is used, for example, for either of the readout photoconductive layer or recording photoconductive layer, and a photoconductive material consisting primarily of sintered compacts of Bi₁₂MO₂₀ (M is one of Ge, Si or Ti) is used for the other.

A method for manufacturing an image recording medium by bonding an active matrix substrate having an electric charge storing capacitor and a TFT (thin film transistor) to an opposing substrate having photoconductivity (compound semiconductor such as CdTe, CdZnTe or the like) using an anisotropic conductive adhesive is disclosed in U.S. patent No. 6,262,408 as a method for manufacturing an image recording medium by bonding different kinds of materials together.

Thus, in manufacturing an image recording medium that includes a photoconductive layer consisting primarily of a-Se, and a photoconductive layer consisting primarily of sintered compacts of Bi₁₂MO₂₀, it is conceivable that the image recording medium may be manufactured by bonding a single readout photoconductive layer or a layer composite including the readout photoconductive layer to a single recording photoconductive layer or a layer composite including the recording photoconductive layer using an anisotropic conductive adhesive.

The use of anisotropic conductive adhesive for bonding, however, requires heating, pressurizing, or the like in order to force the diameter of the conductive particles included in the adhesive to conform to the application thickness of the adhesive when performing the bonding. But a-Se is prone to degradation or destruction by heat or high pressure, and is degraded or destroyed by the heat or pressure applied thereto when the bonding is performed. Thus, the method using the anisotropic conductive adhesive is not suited for manufacturing an image recording medium having a photoconductive layer that includes a-Se.

The present invention has been developed in view of the circumstances described above, and it is an object of the present invention to provide a method for manufacturing an image recording medium that includes a photoconductive layer consisting primarily of a-Se, in which the a-Se may be prevented from degradation or destruction.

### SUMMARY OF THE INVENTION

The method for manufacturing an image recording medium of the present invention is a method for manufacturing an image recording medium constituted by a layer composite layered in the order of:
a recording side electrode layer transparent to recording radiation;
a recording photoconductive layer that shows photoconductivity when exposed to the recording radiation;
a charge storage section for storing charges of latent image polarity generated in the recording photoconductive layer;
a readout photoconductive layer that shows photoconductivity when exposed to a readout electromagnetic wave; and
a readout side electrode layer transparent to the readout electromagnetic wave, wherein:
   either of the recording photoconductive layer or readout photoconductive layer consists primarily of a-Se, and the other consists primarily of sintered compacts of Bi-system compound; and
   the photoconductive layer consisting primarily of a-Se is formed by deposition after the photoconductive layer consisting primarily of sintered compacts of Bi-system compound is formed.

The referent of "consists primarily of a-Se" as used herein means that a-Se is included more than or equal to 90% as the major component of the photoconductive layer. Likewise, the referent of "consists primarily of sintered compacts of Bi-system compound" as used herein means that sintered compacts of Bi-system compound is included more than or equal to 90% as the major component of the photoconductive layer.

Further, the referent of "the photoconductive layer consisting primarily of a-Se is formed by deposition after the photoconductive layer consisting primarily of sintered compacts of Bi-system compound is formed" as used herein means that the photoconductive layer consisting primarily of a-Se is formed by depositing the layer on a single layer consisting primarily of sintered compacts of Bi-system compound or on a layer composite that includes the layer consisting primarily of sintered compacts of Bi-system compound.

The recording photoconductive layer may consist primarily of sintered compacts of Bi-system compound, and the readout photoconductive layer may consist primarily of a-Se. Further, the sintered compacts of Bi-system may be sintered compacts of Bi₁₂MO₂₀ (M is one of Ge, Si or Ti) . Still further, the readout photoconductive layer and readout side electrode layer may be bonded together by an adhesive. Preferably, the adhesive is a light curable adhesive.

According to the method for manufacturing an image recording medium of the present invention, the photoconductive layer consisting primarily of a-Se is formed by deposition after the photoconductive layer consisting primarily of sintered compacts of Bi-system compound is formed. This method does not require bonding of the substrate that includes the photoconductive layer consisting primarily of a-Se and the substrate that includes the photoconductive layer consisting primarily of sintered compacts of Bi-system compound together using an anisotropic conductive adhesive. Accordingly, no heating or pressurizing is required in the process of manufacturing an image recording medium and thereby a-Se used is prevented from degradation or destruction. That is, the yield rate of the image recording medium may be improved.

### BRIEF DESCRIPTION OF THE DRAWINGS

Figure 1 is a schematic perspective view of the image recording medium according to an embodiment of the present invention, illustrating the construction thereof.
Figures 2A to 2D are drawings for explaining the method for manufacturing the image recording medium according to an embodiment.
Figure 3 is a schematic configuration diagram of a recording/readout system that includes the image recording medium.
Figures 4A to 4D are drawings for explaining the process of recording an electrostatic latent image in the recording/readout system using a charge model.
Figures 5A to 5D are drawings for explaining the process of reading out the electrostatic latent image in the recording/readout system using a charge model.

### DESCRIPTION OF THE PREFERRED EMBODIMENTS

### (1) Construction of Image Recording Medium and Method for Manufacturing the Medium

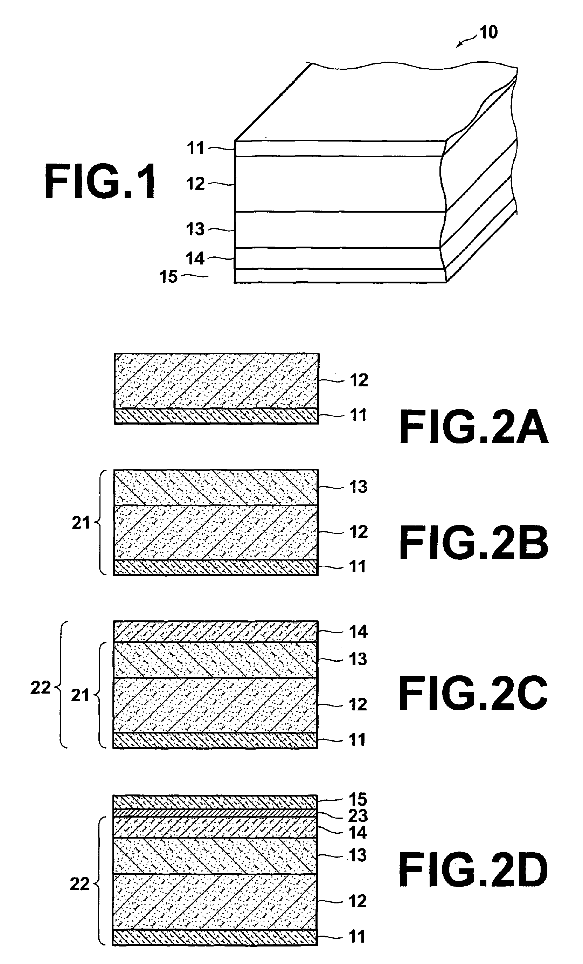

The construction of the image recording medium of the present invention will be described first with reference to Figure 1. Figure 1 is a schematic perspective view of the image recording medium according to an embodiment of the present invention, illustrating the construction thereof. The image recording medium 10 is constituted by a layer composite layered in the order of: a recording side electrode layer 11 transparent to recording radiation (e.g., X-rays) to be described later; a recording photoconductive layer 12 that shows conductivity when exposed to the recording radiation transmitted through the recording side electrode layer 11; a charge transport layer 13 that acts as substantially an insulator against charges charged on the recording side electrode layer 11 (charges of latent image polarity, negative charges for example) and as substantially a conductor for the charges of the opposite polarity (charges of transport polarity, positive charges for example); a readout photoconductive layer 14 that shows conductivity when exposed to readout light to be described later; and a readout side electrode layer 15 transparent to the readout light.

The recording side electrode layer 11 may be made of any material as long as it is transparent to radiation. For example, a transparent glass plate with conductive material applied uniformly thereon (Nesa film or the like), or the like may be used as the recording side electrode layer 11.

A photoconductive material consisting primarily of a-Se is used for either of the recording photoconductive layer 12 or the readout photoconductive layer 14, and a photoconductive material consisting primarily of sintered compacts of Bi-system compound is used for the other. The present embodiment will be described on the assumption that the recording photoconductive layer 12 consists primarily of sintered compacts of Bi₁₂MO₂₀, and the readout photoconductive layer 14 consists primarily of a-Se. Further, instead of the sintered compacts of Bi₁₂MO₂₀ described above, sintered compacts of Bi₁₂M₃O₁₂, a sintered film of polycrystalline substance made of Bi₁₂MO₂₀ (M is at least one of Ge, Si or Ti) having a filling rate of not less than 70% with layer thickness from 50µm to 600µm as described in European patent Publication No. 1376245, sintered compacts of Bi₂O₃ as described in Japanese Patent Application No. 2004-109849, sintered compacts of Bi₂Ti₇O₇ as described in Japanese Patent Application No. 2004-109850, or sintered compacts of BiMO₄ (M is at least one of V, Nb or Ta) as described in Japanese Patent Application No. 2004-279708 may be used for the photoconductive layer.

As for the material of the charge transport layer 13, materials having a greater difference in charge mobility between the negative charges charged on the recording side electrode layer 11 and the opposite positive charges are preferable. These materials include organic compounds such as poly N-vinylcarbazole (PVK), N,N'-diphenyl-N,N'-bis(3-methylphenyl)-[1,1'-biphenyl]-4,4'-dia mine (TPD), discotic liquid crystal, and the like, or semiconductor materials such as TPD-dispersed polymers (polycarbonate, polystyrene, PUK), a-Se doped with 10 to 200 ppm of Cl, and the like. In particular, the organic compounds (PVK, TPD, discotic liquid crystal, and the like) are preferable, since these materials are insensitive to light. Moreover, these materials have generally a small dielectric constant, resulting in small capacitance of the capacitor formed between the charge transport layer 13 and readout photoconductive layer 14, and thereby signal extraction efficiency may be improved when the signal charges are read out. Further, the charge transport 13 may be a selenium arsenic alloy doped with halogen. Here, the amount of the halogen is preferable to be in the range from 10 to 200 ppm in weight. Preferably, the amount of halogen is not greater than 20 ppm in weight if the arsenic is not doped. Incidentally, the image recording medium 10 does not necessarily include the charge transport layer 13.

The readout side electrode layer 15 maybe a transparent glass plate with a conductive material applied uniformly thereon (Nesa film or the like) like the recording side electrode layer 11. But it may be constituted by a comb electrode like that used in the image recording medium as described, for example, in U.S. Patent Application Publication No. 20040227114.

Hereinafter, a method for manufacturing the image recording medium 10 will be specifically described with reference to Figures 2A to 2D. First, the recording side electrode layer 11 and recording photoconductive layer 12 consisting primarily of sintered compacts of Bi₁₂MO₂₀ are formed (Figure 2A). When the charge transport layer 13 is to be included in the image recording medium 10, the charge transport layer 13 is further formed (Figure 2B). Thereafter, the readout photoconductive layer 14 consisting primarily of a-Se is formed by deposition on the layer composite 21 that includes the recording photoconductive layer 12. More specifically, Se material is put on a vacuum deposition board (made of stainless steel or tungsten) which is then heated by the electric current flown through the board and thereby the Se material is heated and evaporated. The layer composite 21 is heated to a temperature in the range from 40 to 70 degrees Celsius, and evaporated Se particles adhere to the layer composite 21 to form an a-Se film on the layer composite 21. When the Se material is deposited, the layer composite 21 is heated to a temperature in the range from 40 to 70 degrees Celsius. But the sintering temperature of the sintered compacts of Bi₁₂MO₂₀ is approximately 800 degrees Celsius, so that substantially no damage is caused to the sintered compacts of Bi₁₂MO₂₀ in the a-Se deposition process. There may be a case where the charge transport layer 13 is not provided between the recording photoconductive layer 12 and readout photoconductive layer 14, or another layer having a certain function is provided between the recording photoconductive layer 12 and readout photoconductive layer 14. In any case, the readout photoconductive layer 14 consisting primarily of a-Se is formed by deposition after the recording photoconductive layer 12 consisting primarily of sintered compacts of Bi₁₂MO₂₀ is formed.

Then, the readout side electrode layer 15 is bonded to the layer composite 22 that includes the readout photoconductive layer 14 by the adhesive 23 (Figure 2D). In the image recording medium 10 shown in Figure 1, the adhesive 23 is omitted for clarity. Preferably, the adhesive 23 is light curable and non-water soluble. Further, the adhesive 23 may be conductive or nonconductive since it is applied thinly and uniformly to the readout side electrode layer 15.

As described above, the readout photoconductive layer 14 consisting primarily of a-Se is formed by deposition after the recording photoconductive layer 12 consisting primarily of sintered compacts of Bi₁₂MO₂₀ is formed. Thus, bonding of the readout. photoconductive layer 14 consisting primarily of a-Se to the layer composite 21 that includes the reading photoconductive layer 12 consisting primarily of sintered compacts of Bi₁₂MO₂₀ by an anisotropic conductive adhesive is not required. Accordingly, no heating or pressurizing is required in the process of manufacturing the image recording medium 10 and thereby a-Se used is prevented from degradation or destruction. That is, the yield rate of the image recording medium 10 may be improved.

### (2)Recording/Readout System Having the Image Recording Medium

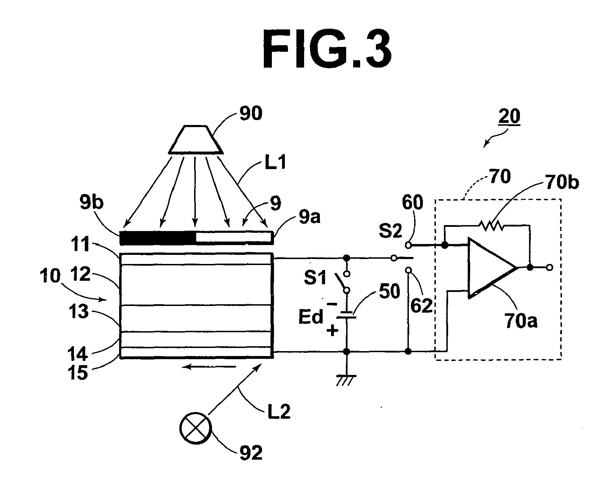

Hereinafter, the method for recording an electrostatic latent image on the image recording medium, and the method for reading out the electrostatic latent image from the medium will be described. The referent of "electrostatic latent image" as used herein means a subject image represented by the charges stored in the image recording medium. Figure 3 is a schematic configuration diagram of a recording/readout system 20 (combined system of an electrostatic latent image recording unit and an electrostatic latent image readout unit) that includes an image recording medium 10. The recording/readout system 20 is constituted by the image recording medium 10; a radiation irradiating section 90; a power source 50; a current detecting section 70; a readout exposure section 92; and switches S1 and S2. Of these, the image recording medium 10, power supply 50, radiation irradiating section 90, and the switch S1 constitute the section corresponding to the electrostatic latent image recording unit. The image recording medium 10, current detecting section 70, switch S2, and readout exposure section 92 constitute the section corresponding to the electrostatic latent image readout unit. In the image recording medium 10 shown in Figures 3 to 5, the adhesive 23 shown in Figure 2D is omitted for clarity.

The recording side electrode 11 of the image recording medium 10 is connected to the negative pole of the power source 10 through switch S1 and one end of the switch S2. The terminal 60 of the switch S2 is connected to the current detecting section 70. The terminal 62 of the switch S2 is connected to the readout side electrode layer 15 of the image recording medium 10, positive pole of the power supply 50, and ground. The current detecting section 70 includes a detecting amplifier 70a, which is an operational amplifier, and a feedback resister 70b, thereby forming a so-called a current/voltage conversion circuit.

A subject 9 is positioned above the recording side electrode layer 11. The subject 9 includes a section 9a which is transparent to recording radiation L1 and a blocking section (light shielding section) 9b which is opaque to the recording radiation L1. The radiation irradiating section 90 is provided for irradiating the recording radiation L1 uniformly on the subject 9. The readout exposure section 92 is provided for scan exposing with readout light L2, such as an infrared laser beam, LED, or EL, in the direction indicated by the arrow in Figure 3. Preferably, the readout light L2 is in the form of a beam focused into a small diameter.

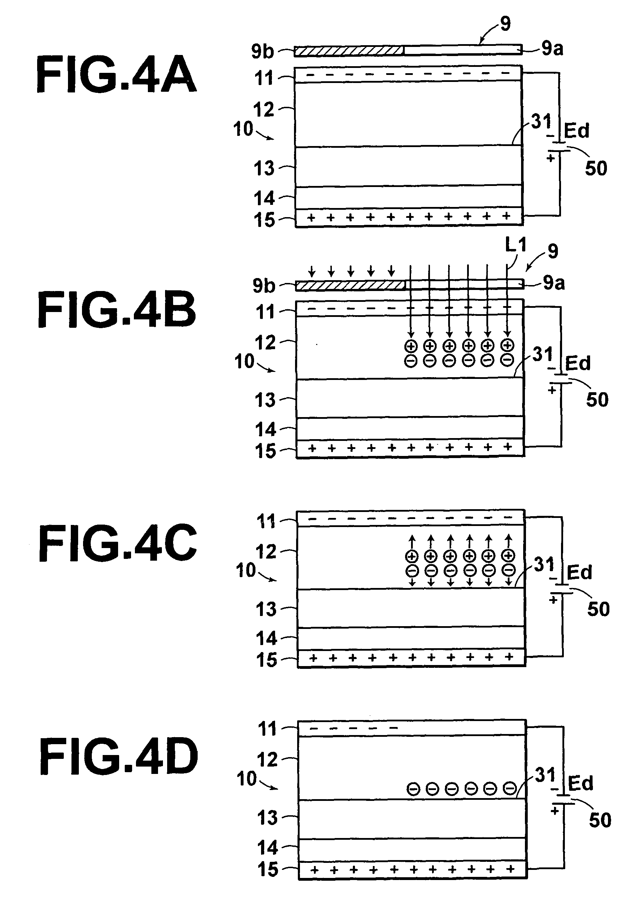

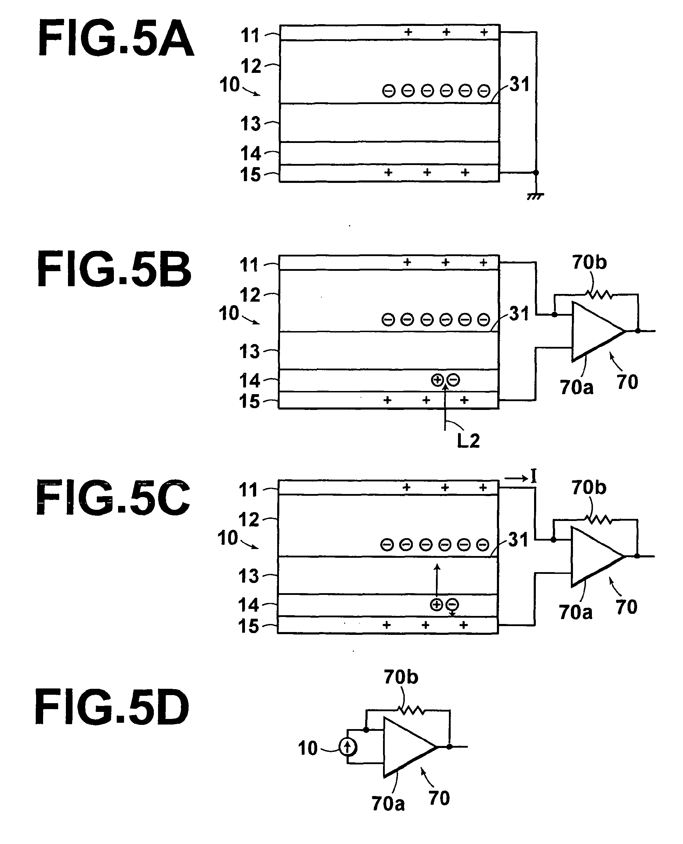

Figures 4A to 4D are drawings for explaining the recording process of an electrostatic latent image in the recording/readout system 20 using a charge model. Figure 5A to 5B are drawings for explaining the readout process of an electrostatic latent image in the recording/readout system 20 using a charge model. Initially, the switch S2 is switched open in which the switch S2 touches neither the terminal 61 nor terminal 62. Then, the switch S1 is switched on to apply a DC voltage Ed supplied by the power supply 50 between the recording side electrode layer 11 and readout side electrode layer 15 such that negative charges are charged on the recording side electrode layer 11 and positive charges are charged on the readout side electrode layer 15 (Figure 4A) . This creates a parallel electric field in the image recording medium 10 between the recording side electrode layer 11 and readout side electrode layer 15.

Then, the recording radiation L1 is irradiated uniformly onto the subject 9 from the radiation irradiating section 90. Some of the recording radiation L1 transmits through the transparent section 9a of the subject 9 and further transmits through the recording side electrode layer 11. The recording photoconductive layer 12 shows conductivity when exposed to the recording radiation L1 transmitted through the recording side electrode layer 11. This process is like the operation of a variable resistor that varies its resistance value according to the radiation dose of the recording radiation L1. The resistance value depends on the amount of positive/negative charge pairs generated by the recording radiation L1, and if the radiation dose of the recording radiation L1 transmitted through the subject 9 is small, the variable resistor shows a high resistance value. The negative and positive charges generated by the recording radiation L1 are indicated by encircled minus (-) signs and encircled plus (+) signs respectively in the drawings.

The positive charges generated in the recording photoconductive layer 12 move rapidly through the recording photoconductive layer 12 toward the recording side electrode layer 11, and disappear through charge recombination with the negative charges charged at the interface between the recording side electrode layer 11 and recording photoconductive layer 12(Figure 4C and 4D. In the mean time, the negative charges generated in the recording photoconductive layer 12 move through the recording photoconductive layer 12 toward the charge transport layer 13. The charge transport layer 13 acts as an insulator against the charges of the latent image polarity which is the same polarity of the charges charged on the recording side electrode layer 11 (negative charges in the present example). Thus, the negative charges moving through the recording photoconductive layer 12 are blocked at the charge storage section 31 formed at the interface between the recording photoconductive layer 12 and charge transport layer 13. That is, the negative charges moving through the recording photoconductive layer 12 are stored in the charge storage section 31. The amount of charges stored in the charge storage section 31 depends on the amount of negative charges generated in the recording photoconductive layer 12 or the radiation dose of the recording radiation L1 transmitted through the subject 9.

Here, the description has been made that the charge storage section 31 is formed at the interface between the recording photoconductive layer 12 and charge transport layer 13. If the charge transport layer 13 is not included in the image recording medium 10, the charge storage section 31 is formed at the interface between the recording photoconductive layer 12 and readout photoconductive layer 14.

In the mean time, the recording radiation L1 does not transmit through the light shielding section 9b of the subject 9, so that the portion of the image recording medium 10 that lies under the light shielding section 9b of the subject 9 shows no changes (Figures 4B to 4D) . As described above, by irradiating the reading radiation L1 on the subject 9, charges are stored in the charge storage section 31 according to the subject image.

Hereinafter, the electrostatic latent image readout process will be described with reference to Figures 5A to 5D. Initially, the voltage supply to the image recording medium 10 is terminated by switching off the switch S1. Then, the rearrangement of charges is implemented by connecting the opposite end of the switch S2 to the terminal 62 and making the recording side electrode layer 11 and readout side electrode layer 15 at the same potential.

When the readout side electrode layer 15 is scan exposed with the readout light L2 by the readout exposure section 92, the readout light L2 transmits through the readout side electrode layer 15, and the readout photoconductive layer 14 irradiated by the readout light L2 transmitted through the readout side electrode layer 15 shows conductivity. This is due to the fact that the positive/negative charge pairs are generated in the readout photoconductive layer 14 when exposed to the readout light L2, like the positive/negative charge pairs are generated in the recording photoconductive layer 12 when exposed to the recording radiation L1(Figure 5B). The negative and positive charges generated by the readout light L2 are indicated by encircled minus (-) signs and encircled plus (+) signs respectively in the drawings as in the recording process.

A very strong electric field (intense electric field) is formed between the charge storage section 31 storing the charges of latent image polarity and readout electrode layer 15 depending on the total film thickness of the readout photoconductive layer 14 and charge transport layer 13, and the amount of the charges of latent image polarity. Here, since the charge transport layer 13 acts as a conductor for positive charges, the positive charges generated in the readout photoconductive layer 14 move rapidly through the charge transport layer 13 attracted by the negative charges stored in the charge storage section 31 and disappear through charge recombination with the negative charges at the charge storage section 31. In the mean time, negative charges generated in the readout photoconductive layer 14 are recombined with the positive charges of the readout side electrode layer 15 and disappear (Figure 5C). The readout photoconductive layer 14 is scan exposed with a sufficient amount of light by the readout light L2 to cause the negative charges stored in the charge storage section 31, i.e. electrostatic latent image to be disappeared through the charge recombination. Disappearance of the charges stored in the image recording medium 10 in the manner as described above means that a current I caused by the movement of the charges flows in the image recording medium 10. That is, the image recording medium 10 may be expressed by the equivalent circuit representing a current source that flows an amount of current according to the amount of charges stored therein like that shown in Figure 5D.

By scan exposing each of the sections corresponding to each of the pixels on the image recording medium 10 by the readout light L2 in the manner as described above, the amount of charges of each of the sections corresponding to each of the pixels may be read out. That is, by scan exposing the entire region of the readout side electrode layer 15, the electrostatic latent image recorded in the image recording medium 10 may be read out.

The image recording medium 10 according to the present embodiment includes the recording photoconductive layer 12 and charge transport layer 13 with the charge storage section 31 being formed at the interface between the recording photoconductive layer 12 and charge transport layer 13. But the charge transport layer 13 may be replaced by a trap layer, in which case the latent image charges are captured by the trap layer, and stored in the trap layer or at the interface between the trap layer and recording photoconductive layer 12.

## Claims

1. A method for manufacturing an image recording medium constituted by a layer composite layered in the order of:
a recording side electrode layer (11) transparent to recording radiation;
a recording photoconductive layer (12) that shows photoconductivity when exposed to the recording radiation;
a charge storage section (31) for storing charges of latent image polarity generated in the recording photoconductive layer (12);
a readout photoconductive layer (14) that shows photoconductivity when exposed to a readout electromagnetic wave; and
a readout side electrode layer (15) transparent to the readout electromagnetic wave, wherein:
either of the recording photoconductive layer (12) or readout photoconductive layer (14) consists primarily of a-Se, and the other consists primarily of sintered compacts of Bi-system compound; and
the photoconductive layer consisting primarily of a-Se is formed by deposition after the photoconductive layer consisting primarily of sintered compacts of Bi-system compound is formed.

2. The method for manufacturing an image recording medium according to claim 1, wherein the recording photoconductive layer (12) consists primarily of sintered compacts of Bi-system compound, and the readout photoconductive layer (14) consists primarily of a-Se.

3. The method for manufacturing an image recording medium according to claim 1 or 2, wherein the sintered compacts of Bi-system compound are sintered compacts of Bi₁₂MO₂₀ (M is one of Ge, Si or Ti).

4. The method for manufacturing an image recording medium according to claim 2 or 3, wherein the readout photoconductive layer (14) and readout side electrode layer (15) are bonded together by an adhesive (23).

5. The method for manufacturing an image recording medium according to claim 4, wherein the adhesive (23) is a light curable adhesive.
